(19) Europäisches Patentamt
European Patent Office
Office européen des brevets

(11) **EP 2 141 806 A1**

(12) **EUROPEAN PATENT APPLICATION**

(43) Date of publication:
06.01.2010 Bulletin 2010/01

(51) Int Cl.:
*H03H 11/12* (2006.01)     *H03L 7/081* (2006.01)
*H03J 3/04* (2006.01)      *H03J 3/16* (2006.01)

(21) Application number: 08159561.3

(22) Date of filing: 02.07.2008

(84) Designated Contracting States:
AT BE BG CH CY CZ DE DK EE ES FI FR GB GR HR HU IE IS IT LI LT LU LV MC MT NL NO PL PT RO SE SI SK TR
Designated Extension States:
AL BA MK RS

(71) Applicant: **Abilis Systems Sarl**
**1228 Plan-Les-Ouates (CH)**

(72) Inventors:
• **Eichrodt, Christian**
**34160 Collonges sur Salève (FR)**

• **Lambertet, Cedric**
**74160, St. Julien en Genevois (FR)**
• **Moore, David**
**Carp Ontario K0A 1L0 (CA)**

(74) Representative: **P&TS**
**Patents & Technology Surveys SA**
**Rue des Terreaux 7**
**Postfach 2848**
**2001 Neuchâtel (CH)**

(54) **System for automatic tuning of an analogue filter**

(57)     A DVB receiver including one or more digitally-tuneable lowpass filters in a direct baseband conversion stage. Tuning of the lowpass filters is achieved in a control loop, including a bandpass replica filter whose central frequency is locked to that of a reference oscillator. The topology of the replica filter is chosen so as to have a 90° shift at a reference frequency, and the error signal for the control loop is obtained by mixing input and output of the replica filter.

Fig. 4

EP 2 141 806 A1

**Description**

Field of the invention

Embodiments of the present invention include a tuneable analogue filter, in particular a high-order low pass filter whose cut-off frequency can be tuned by an appropriate control input, and a system to automatically tune such a filter to a predetermined value of the cut-off frequency.

Other embodiments of the invention relate to a radio receiver for a digital modulated signal of the direct-conversion type, without intermediate frequency stages, in which such filter is used to extract a baseband signal. In particular, these embodiments relate to a receiver for a COFDM signal, as prescribed, for example, in the DVB standard. It is to be understood, however, that the invention is not limited to this particular application.

Description of related art

Analogue active filters are used in several electronic components and systems and are, in particular, a fundamental element in radio receivers and wireless data communication. Due to the increasing demand for low power consumption, small size, and reduced cost, it is known to realise such wireless systems in a single semiconductor chip integrating together digital and analogue elements.

In a DVB receiver, for example, the radio signal received and processed by a UHF stage is converted to a low-frequency signal, for example a baseband signal or an IF signal, by the well-known technique of mixing it with the signal provided by a local oscillator and filtering it with one or more low-pass filters (in the case of a direct conversion receiver) or band-pass filters (for an heterodyne receiver). Since the transfer function of the filters is critical to determining selectivity and overall performance of the receiver, specifications of these low-pass filters are quite demanding.

Active filters can be realised in integrated circuits by means of several known techniques.

Switched-capacitor filters, for example, are accurate and compact, yet need a high clock frequency to sample the signal, and more over suffer from aliasing and a relatively high noise figure.

Gm-C or OTA-C filters consist of an element of gain Gm connected to a capacitor C. Since it is straightforward to provide an amplifier whose gain Gm can be varied by tuning the bias current, these filters are often used when the filter must be tuned. Both Gm and C, however, can not be predetermined within tight tolerances, and are largely dependent on process and temperature. Several solutions have therefore been proposed to automatically tune a Gm-C filter.

US7164311, for example, discloses a system in which a Gm-C filter is combined with a replica filter having the same circuital disposition. The replica filter is connected in a feedback loop, turning it effectively into a free-running oscillator, whose frequency can be varied by acting on its bias current. A PLL circuit is used to lock its oscillation frequency with that of a reference frequency. The same bias current is applied to the Gm-C filter, thereby linking its cut-off frequency with that of the reference oscillator. Similar solutions are also disclosed by WO2004084408 and US6285865.

These solutions however suffer from limited linearity. Moreover it is difficult to limit the amplitude of the signal of the free-running oscillator within the linear range. Thus the replica filter typically operates with signals having a different dynamics than the main filter, this difference can reduce tuning accuracy.

The technical literature also discloses several examples of active RC filters, in which the desired transfer function is synthesized by combining integrator elements (C-feedback amplifiers) and summing elements (R-feedback amplifiers). Active RC filter are highly linear but, when they are integrated in an IC chip, they suffer from the limited component accuracy due to process spread and temperature drift.

Accordingly, there is a need for a way to provide a precise filter that can be integrated in an IC chip, in particular for acting as a low-pass filter in a direct-conversion receiver.

Brief summary of the invention

According to the invention, these aims are achieved by means of the object of claim 1, while dependent claims relate to important optional features of the invention.

Brief Description of the Drawings

The invention will be better understood with the aid of the description of an embodiment given by way of example and illustrated by the figures, in which:

Fig. 1 shows a schematic representation of a downconversion stage of a DVB receiver according to one aspect of the invention.

Figure 2a illustrates schematically a Bode diagram of a lowpass filter according to one aspect of the invention.

Figure 2b illustrates schematically a passive equivalent circuit of the lowpass filter whose response is shown in figure 2a.

Figure 3 shows a simplified detail of the circuit used to modify the transfer function of the tuneable filter of the invention.

Figure 4 illustrates schematically a DVB receiver including two tuneable lowpass filters according to one aspect of the invention.

Figure 5 is a plot representing a possible variation of the phase shift introduced by the replica filter of the invention.

<u>Detailed Description of possible embodiments of the Invention</u>

While the invention, as stated above, may be usefully applied to a variety of tuneable filters, in any appropriate application, we will discuss in detail its application to a DVB receiver, it being understood that this is purely for the sake of simplicity, and is not a limiting feature.

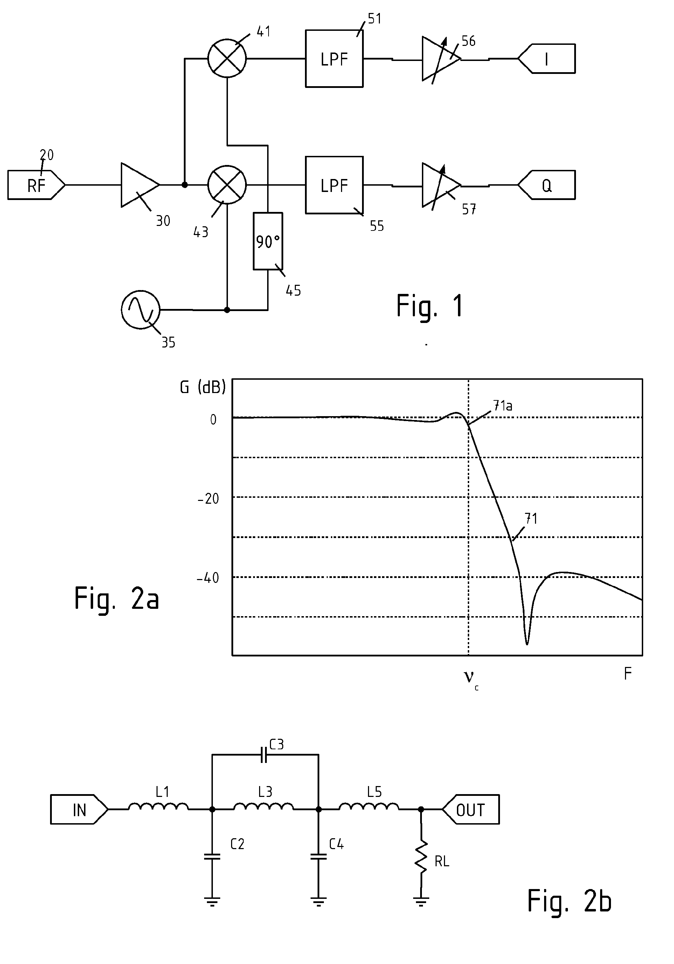

Figure 1 illustrates the analogue input stage of a DVB receiver according to one preferred variant of the present invention. This device comprises a radiofrequency input 20, connected for example to a suitable antenna, and an optional RF stage 30. The RF stage may include, typically, a low-noise radiofrequency amplifier (LNA), as well as other conventional component, like filters, overvoltage protections, tuned circuit, and so on, according to the needs.

To be specific, according to one embodiment of the invention, the DVB signal whose reception is intended is a multicarrier signal having a central frequency close to 600 MHz, and a bandwidth of $\pm 3.75$ MHz, these values being typical for the DVB standard. The radiofrequency signal present at the output of the RF stage 30 is directly converted, in the presented example, to a baseband signal. To this effect, the local oscillator 35 is tuned to match the central frequency of the desired DVB channel, and the two mixers 41 and 43 shift, in a conventional way, the spectrum of the incoming RF signal by an amount equal to the frequency of the local oscillator 35. The two mixers 41 and 43 receive the same RF signal, but the phase shifter 45 changes the phase of the local oscillator signal fed to the mixer 43 by 90°. In this way one obtains, as it is known in the art, both an in-phase and a quadraphase component of the signal.

The low-pass filters 51 and 55 are needed to isolate the baseband signal from interfering signals in the adjacent channels. These filters determine the frequency selectivity of the receiver, and it is therefore desired that they should have a steep transition outside of the passband. Variable gain stages 56 and 57 amplify the signal at outputs I and Q to a suitable level.

Figure 2a shows the gain 71 of a preferred realization of filters 51 and 55 as 5th order elliptical filters. This configuration offers the steepest gain transition, at the expense of some ripple both in the passband and in the stopband, which are however tolerable in the selected application. The exact position of the corner frequency 71 a, however, is important. Too low a frequency would induce a loss of signal in some subcarriers of the DVB signal. The corner frequency can not be placed too high either, because this would let in undesired interference from the adjacent channels.

Preferably the DVB receiver of the present invention is realized in a specialized integrated circuit including, beside the analogue radio receiver of figure 1, ADC and digital processing stages providing a complete DVB solution on a chip. Digital DVB receivers are generally known in the art. The detailed structure of the ADC and digital processing stages is of little consequence for the present invention; therefore it will not be described here.

The following specification will refer, for the sake of simplicity, to particular filter circuits, often represented by an equivalent RLC circuit. It must be understood, however, that each particular filter can be realized in many equivalent ways, all included in the scope of the present invention. Known filter design techniques combine several multi-input integrators, differentiators and linear sum circuits in a network governed by the same differential equation as the passive prototype. Inductors, in particular, can not be effectively miniaturized, and filter synthesis techniques allow replacing them with networks of active elements. Filter synthesis techniques are disclosed in many reference texts and will not be discussed in further detail here.

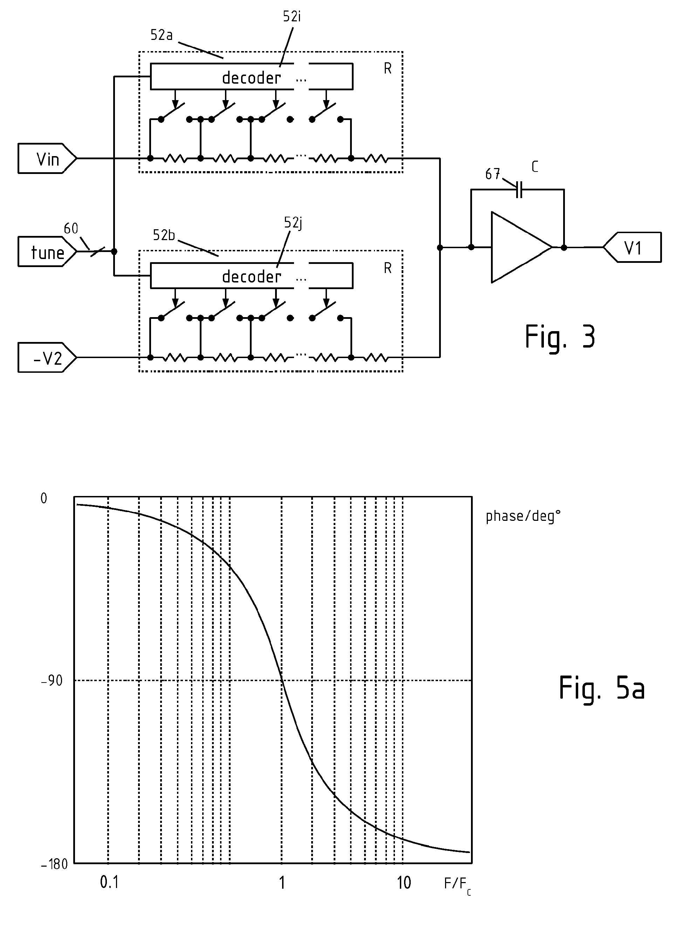

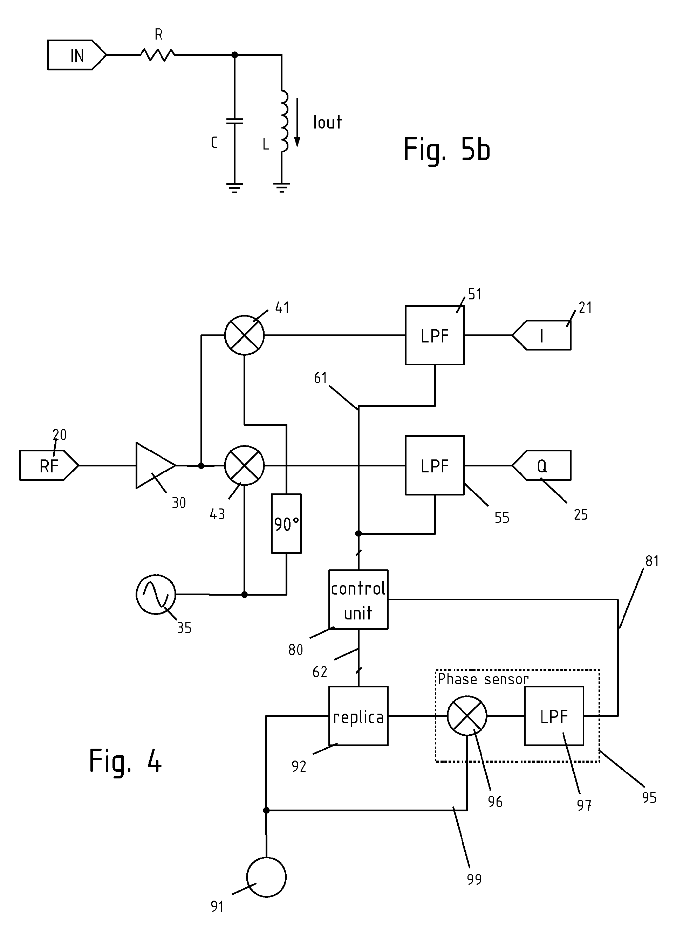

Figure 2b illustrates schematically a passive realization of the filter whose gain is shown in figure 2a. Inherent tolerances of conventional integrated circuit fabrication techniques do not allow positioning of the corner frequency of the lowpass filters 51 and 55 with a satisfactory precision and stability. Hence the circuit of the invention implements an automatic tuning system that will now be described with reference to figures 3 and 4.

The lowpass filter of figure 2b could be implemented, for example, by five integrators and one differentiator, whose transfer functions correspond to the impedances of the passive elements L1, L3, L5, C2, C3, C4 in Fig. 2b as follows:

$$\begin{cases} V_1 = \dfrac{(V_{in} - V_2)}{s(RC)_1} & (L1) \\[2ex] V_2 = \dfrac{(V_1 - D_3 - V_3)}{s(RC)_2} & (C2) \\[2ex] V_3 = \dfrac{(V_2 - V_4)}{s(RC)_3\, a} & (L3) \\[2ex] D_3 = s(RC)_3\, b \cdot (V_2 - V_4) & (C3) \\[2ex] V_4 = \dfrac{(D_3 + V_3 - V_{out})}{s(RC)_4} & (C4) \\[2ex] V_{out} = \dfrac{(V_4 - V_{out})}{s(RC)_5} & (L5) \end{cases} \qquad (1)$$

in which the factors $(RC)_1$ - $(RC)_5$ denote the time constant of the integrators or differentiators

Figure 3 illustrates, by way of example, an integrator stage corresponding to the equation *(L1)* in the system (1) above. The other equations of the system are implemented similarly. The circuit is drawn as single-ended for simplicity. In many cases, however, it would be realized in a differential configuration.

The integrator of figure 3 includes two digitally variable resistors 52a and 52b comprising a bank of resistors that can be selectively inserted or excluded by the switches controlled by decoders 52i and 52j, in order to modify the resistance value according to a digital multi-bit control signal 60. Preferably, the resistors 52 and/or capacitors 67 have values proportional to successive powers of two, to provide a linear control with a simple decoding circuitry.

The time constant RC of the integrator of figure 3 can be varied according to the digital value present on control line 60. The circuit of figure 3 can be varied in many ways, maintaining this function, that are all included in the scope of the present invention. In particular, the feedback capacitor 67 could be digitally variable, in the same way as the resistances 52a and 52b. The RC value could be adjusted by acting on the value of variable capacitor 67, or of resistances 52a-b, or of both.

Using variable integrators and differentiators as building blocks, it is possible to obtain a lowpass filter having a desired transfer function, and whose corner frequency can be controlled by a multi-bit digital control signal. Other filter synthesis techniques that do not use integrators and differentiators are known, but the skilled person would readily adapt the system of the invention to these, so they will not be further described, though the present invention encompasses them. The digital control signal could also be replaced, within the scope of the invention, by an analogue control signal.

The automatic-tuning circuit of figure 4 comprises a pair of identical digitally-tuneable lowpass filters 51 and 55, making part of a DVB receiver as in figure 1, and connected to the same digital tuning signal 61.

The circuit of figure 4 also includes a replica filter 92 shown in the passive equivalent network of figure 5b. Note that the output of the replica filter is the current flowing along the inductor L. The plot of figure 5a represents the phase shift of the replica filter 92. The replica filter has a predetermined 90° phase shift at the given central frequency $F_c$.

The replica filter 92 is synthesized in a similar manner as the lowpass-filter of figure 2b using two integrators and one analogue sum which fulfil the Kirchhoff circuit laws of the passive RLC equivalent 5b.

$$\begin{cases} I_1 = \dfrac{(V_{in} - V_2)}{R} \\[2ex] V_2 = \dfrac{1}{s\,C} \cdot (I_1 - I_{out}) \\[2ex] I_{out} = \dfrac{1}{s\,L} \cdot V_2 \end{cases} \qquad (2)$$

Importantly, the building blocks, i.e. the integrators, differentiators and sum elements that are used in the synthesis of filter 92 are identical to building blocks used in the synthesis of lowpass filters 51 and 55.

Reverting to figure 4, the input of replica filter 92 is connected to a reference frequency signal 91, and its output is fed to a phase-sensitive circuit 95, that provides a signal related to the phase shift introduced by the replica filter 92. In a preferred variant, shown in figure 4, the phase sensitive circuit 95 has a mixer 96 that mixes the filter's output with the input, and a lowpass filter 97, that extracts the DC component of the mixed filter. The phase shift of 90° corresponds to a zero DC component. Hence it is particularly simple to use the DC component as error signal in a control loop. In other variants, however, the transfer function of the replica filter 92 could be different. Note that it is not strictly required that the replica filter should be tuned to a phase shift of 90°. In fact the circuit of the invention can be modified to lock any desired phase shift in the replica filter 92, for example by digitally shifting the signal on the line 99.

The signal 81 generated by the phase sensitive circuit 95 is fed to the control unit 80 that sets the tuning input 62 of the replica filter attempting, for example, to keep the signal 81 at zero value. In doing so, the central frequency of the replica filter 92 is locked to that of the reference frequency signal 91.

The lowpass filters 51 and 55 are controlled by tuning signal 61 generated by control unit 80. The tuning signal 61 is the same as the replica tuning signal 62, or is derived from it. Since the lowpass filters 51 and 55 and the replica filter 92 are built similarly and from the same constitutive blocks, the effect of process spreads and thermal drifts is predictably similar in the replica filter and in the tuneable filters, and they are affected by the same errors and drifts. The control unit 80, by locking the central frequency of the replica filter to that of the reference clock 91, ensures that the corner frequencies of low-pass filters 51 and 55 remain in a predetermined and repeatable relationship with that reference frequency, compensating for thermal drifts and process-induced tolerances.

The tuning system of the invention is as accurate as the reference frequency signal 91. Since the latter is typically derived by digital divisions of a crystal oscillator, the transition frequency of lowpass filters 51 and 57 can be determined with great precision. Preferably the duty cycle of the reference signals 91 should be precisely 50%, otherwise a bias in the measurement is introduced. This can be accomplished in many known ways.

Though the presented example dealt with a low-pass filter that is automatically tuned with the help of a replica circuit that has the characteristics of a low-pass filter, the invention is not limited to these, but could as well be realized as a system for tuning any tuneable circuit, for example a high-pass, band-pass, band-suppression or all-pass filter. The replica filter needs not be a low-pass filter, but could be any circuit having the appropriate frequency-dependent phase shift.

**Claims**

1. A system for the automatic tuning of an active electronic filter whose transfer function is affected by production process spreads and thermal drifts, comprising:

   a tuneable filter having a control input operatively arranged to modify a transfer function of the tuneable filter, a replica filter having a replica control input operatively arranged to modify a transfer function of the replica filter, the variations of the transfer function of the replica filter and of the transfer function of the tuneable filter due to process spread and thermal drift being related, the input of the replica filter being connected to a reference frequency signal,

   **characterized by** a phase sensitive circuit, operatively arranged to detect a phase difference between an input and an output of the replica filter, and a control unit acting on the replica control input and to the control input of the tuneable filter in order to maintain the phase difference between the input and the output of the replica filter at a predetermined value.

2. The system of the preceding claim, wherein the phase sensitive circuit includes a mixer, mixing the output of the replica filter with the reference frequency signal, followed by a low pass filter.

3. The system of any of the preceding claims, wherein the tuneable filter and the replica filter include a bank of switched resistors and/or capacitors, operatively arranged to modify the value of resistors and/or capacitors in the tuneable filter, respectively in the replica filter.

4. The system of the preceding claim, wherein the resistors and/or capacitors have values proportional to successive powers of two, wherein the control input and the replica control input are digital inputs.

5. The system of any of the preceding claims, wherein transfer functions of the tuneable filter and the replica filter are different.

6. The system of the preceding claim, wherein the tuneable filter is a low-pass filter, and/or the replica filter is a low-pass filter.

7. The system of any of the preceding claims, wherein the replica filter comprises a plurality of constitutive blocks identical to corresponding constitutive blocks of the tuneable filter, whereby the effect of process spreads and thermal drifts is predictably similar in the replica filter and in the tuneable filter.

8. The system of the preceding claim, wherein the replica filter and the tuneable filter are realized on the same semiconductor chip or integrated circuit.

9. The system of any of the preceding claims, wherein the tuneable filter is a low-pass filter providing a baseband signal in a DVB receiver.

10. Use of the system of any of the preceding claims in a DVB receiver.

Fig. 1

Fig. 2a

Fig. 2b

Fig. 3

Fig. 5a

Fig. 5b

Fig. 4

Europäisches
Patentamt

European
Patent Office

Office européen
des brevets

## EUROPEAN SEARCH REPORT

Application Number

EP 08 15 9561

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/212447 A1 (NYSTROM CHRISTIAN [SE] ET AL) 28 October 2004 (2004-10-28) * paragraph [0023] - paragraph [0046] * * figures * ----- | 1-10 | INV. H03H11/12 H03L7/081 H03J3/04 H03J3/16 |
| X | US 5 942 935 A (OKANOBU TAIWA [JP]) 24 August 1999 (1999-08-24) * column 5, line 49 - column 10, line 17 * * figures 6-9 * ----- | 1,2,7-10 | |
| A | US 2003/045263 A1 (WAKAYAMA MYLES [US] ET AL WAKAYAMA MYLES [US] ET AL) 6 March 2003 (2003-03-06) * paragraph [0008] * * paragraph [0055] * * paragraph [0058] - paragraph [0061] * * paragraph [0066] * * paragraph [0070] * * paragraph [0092] - paragraph [0102] * * paragraph [0118] - paragraph [0128] * * paragraph [0133] - paragraph [0138] * * figures 1-3,8-11,13,17,18 * ----- | 1,3,4, 6-10 | |
| | | | TECHNICAL FIELDS SEARCHED (IPC) H03L H03H H03J |

The present search report has been drawn up for all claims

| Place of search | Date of completion of the search | Examiner |
|---|---|---|
| The Hague | 13 November 2008 | Balbinot, Hervé |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons

& : member of the same patent family, corresponding
　　document

EPO FORM 1503 03.82 (P04C01)

**EP 2 141 806 A1**

## ANNEX TO THE EUROPEAN SEARCH REPORT
## ON EUROPEAN PATENT APPLICATION NO.

EP 08 15 9561

13-11-2008

| Patent document cited in search report | | Publication date | Patent family member(s) | | Publication date |
|---|---|---|---|---|---|
| US 2004212447 | A1 | 28-10-2004 | NONE | | |
| US 5942935 | A | 24-08-1999 | NONE | | |
| US 2003045263 | A1 | 06-03-2003 | US 2007117507 | A1 | 24-05-2007 |
| | | | US 2004166799 | A1 | 26-08-2004 |

For more details about this annex : see Official Journal of the European Patent Office, No. 12/82

**REFERENCES CITED IN THE DESCRIPTION**

**Patent documents cited in the description**

- US 7164311 B
- WO 2004084408 A
- US 6285865 B